# EUROPEAN PATENT SPECIFICATION

(11) **EP 1 724 848 B1**
(45) Date of publication and mention of the grant of the patent: **15.08.2018**
(21) Application number: 06290785.2
(22) Date of filing: 15.05.2006
(51) Int. Cl.: H01L 33/62, H01L 33/54

(54) **Method of manufacturing a light emitting device package**
Verfahren zur Herstellung einer lichtemittierenden Vorrichtung
Procédé de fabrication d'un boitier de dispositif lumineux

(30) Priority: 17.05.2005 KR 20050041235
(43) Date of publication of application: 22.11.2006
(73) Proprietor: LG Electronics, Inc., Seoul 150-875 (KR); LG Innotek Co., Ltd., Seoul, 04637 (KR)
(72) Inventor: Kim, Geun Ho, Gangnam-gu 135-960 Seoul (KR); Lee, Seung Yeob, 402, Jeongseok Green Villa, Seongnam-si Gyeonggi-do 462-837 (KR)
(74) Representative: Cabinet Plasseraud

(56) References cited:
- WO-A2-2006/034671
- JP-A- 2005 057 239
- US-A- 4 936 808
- US-A1- 2002 171 090

## Description

### BACKGROUND

The present invention relates to a light emitting device package and a method for manufacturing the same.

In general, a light emitting device basically comprises a junction of p-type and n-type semiconductors, and is a kind of optoelectronic device in which upon application of a voltage thereto, energy corresponding to a bandgap of a semiconductor is emitted in the form of light due to combination of electrons and holes.

The amount of light output from the light emitting device increases in proportion to an electric current flowing through the device.

Studies on such a light emitting device has been actively conducted as power consumption is low, harmful substances are not used, color reproducibility is good and a life span is extended as long as tens of thousands hours or more.

A light emitting device such as a light emitting diode (LED) or laser diode using a III-V group or II-VI group compound semiconductor material of a direct transition type semiconductor can implement red, green, blue colors and ultraviolet rays by means of a thin film growth technique and development of a device material.

Further, the light emitting device can implement a white light source with superior efficiency by using a fluorescent substance or by combining light.

With the development of such techniques, the light emitting device has been used not only in a device for a display but in a variety of fields such as a transmitting module, a backlight of a liquid crystal display (LCD), a lighting system capable of substituting for a fluorescent lamp or incandescent bulb, a sign board, a traffic light, and an instrument panel of a car.

Meanwhile, if a substrate is n-type in a red or infrared light emitting device, an n-type layer, an active layer and a p-type layer are sequentially laminated on a top surface of the substrate, an n-type electrode layer is formed beneath a bottom surface of the substrate, and a p-type electrode layer is formed on a top surface of the p-type layer.

If a forward voltage is applied between the n-type and p-type electrode layers in the red light emitting device, electrons are injected into the active layer through the n-type layer and holes are injected into the active layer through the p-type layer.

At this time, the electrons and the holes injected into the active layer are recombined and then emit light corresponding to a bandgap or an energy level difference of the active layer.

As described above, the red or infrared light emitting device is provided with a structure where the p-type and n-type electrode layers face each other with the substrate there between.

Accordingly, at least one electrode should be subjected to wire bonding in the prior art so that the red or infrared light emitting device can come into contact with a submount or a printed circuit board (PCB) and can be electrically connected to other devices.

Therefore, a certain space for wire bonding to the submount or the PCB should be provided. This causes increase in the size of a package, and reduction in reliability of the package due to short or disconnection of a wire.

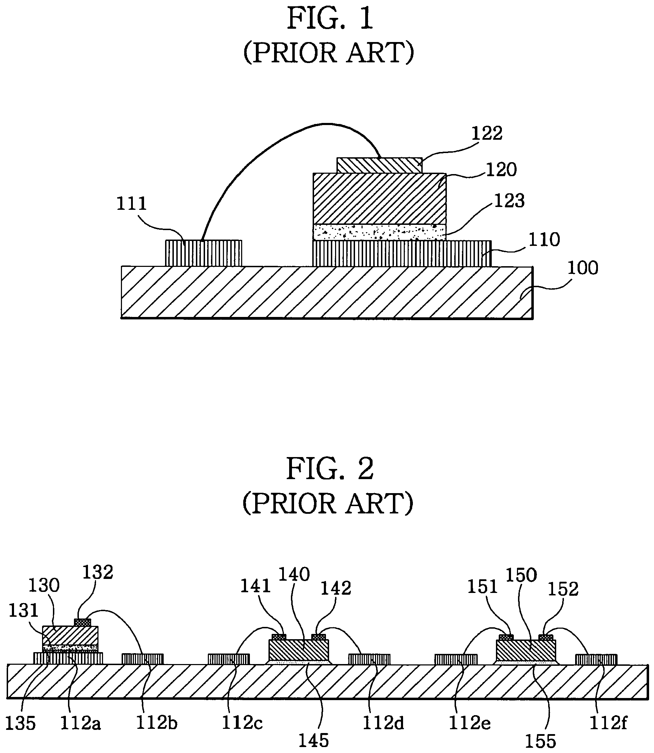

Such a prior art will be described with reference to FIG 1.

FIG. 1 is a sectional view of a conventional light emitting device package using wire bonding. First and second conductive pads (110, 111) are formed on a top surface of a substrate (100) while being spaced apart from each other.

Further, a second electrode layer (123) formed beneath a bottom surface of a light emitting device (120) is bonded to a top surface of the first conductive pad (110), and a first electrode layer (122) formed on a top surface of the light emitting device (120) and the second conductive pad (111) are wire bonded for electrical connection there between.

A submount made of silicone (Si) or ceramic, or a PCB is used for the substrate (100).

The first conductive pad (110) is formed on the top surface of the substrate (100).

Further, the first conductive pad (110) has the same polarity as that of the second electrode layer (123) formed beneath the bottom surface of the light emitting device (120).

For example, if the second electrode layer (123) formed beneath the bottom surface of the light emitting device (120) is n-type, the first conductive pad (110) is also n-type. If the second electrode layer (123) formed beneath the bottom surface of the light emitting device (120) is p-type, the first conductive pad (110) is also p-type.

The second conductive pad (111) is formed on the top surface of the substrate (100) such that it is spaced apart from the first conductive pad (110).

The light emitting device (120) is bonded to the top surface of the first conductive pad (110).

FIG. 2 is a sectional view showing a state where light emitting devices are arrayed and packaged according to a prior art. A plurality of conductive pads (112a, 112b, 112c, 112d, 112e, 112f) are formed on a substrate (100) of the light emitting device package.

In addition, a lower electrode (131) of a red light emitting device (130) is bonded to a top surface of the conductive pad (112a) with a conductive adhesive (135), and an upper electrode (132) of the red light emitting device (130) is wire bonded to another conductive pad (112b).

Further, a green light emitting device (140) is bonded to the substrate (100) with an adhesive (145), and two upper electrodes (141, 142) of the green light emitting device (140) are respectively wire bonded to the two conductive pads (112c, 112d).

Furthermore, a blue light emitting device (150) is bonded to the substrate (100) with an adhesive (155), and two upper electrodes (151, 152) of the blue light emitting device (150) are respectively wire bonded to the two conductive pads (112e, 112f).

Such a light emitting device package mounts red, green and blue light emitting devices on a substrate to implement a package emitting white light. At this time, wire bonding is performed several times.

As described above, there is a disadvantage in that a space for wire-bonding a light emitting device is additionally required in the conventional light emitting device, resulting in increase in the size of a package.

Further, since a bonded wire may be short-circuited or disconnected, reliability for connection between devices suffers.

Furthermore, the wire bonding is not suitable for mass production.

Meanwhile, roughly two methods can be used to fabricate a white light emitting diode. First, there is a single chip-type method in which a fluorescent substance is combined on a blue or UV LED chip to obtain white light. Second is a multi chip-type method in which two or three LED chips are combined with each other to obtain white light. At this time, if where the single chip type method is used, it is essentially required to apply a phosphor on a fabricated LED.

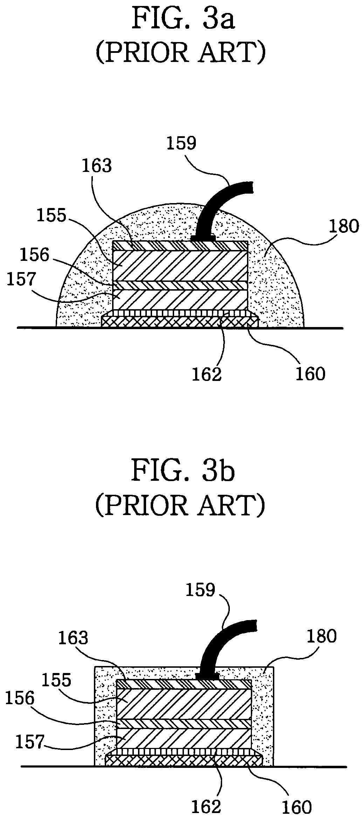

FIGS. 3a and 3b are sectional views schematically showing a state where a phosphor is applied to a conventional light emitting device package. An LED having a p-type layer (157), an active layer (156) and an n-type layer (155), which are sequentially laminated one above another, is joined to a submount (160) with a p-ohmic contact metal layer (162) interposed therebetween, and an n-ohmic contact metal layer (163) is formed on the n-type layer (155).

Here, a wire (159) through which a current is supplied to the LED is bonded to the n-ohmic contact metal layer (163).

At this time, a phosphor is applied to surround the LED and a portion of the wire (159) as shown in FIGS. 3a and 3b.

Generally, in order to form a phosphor thin film, it is preferred that there be no convex or concave portion on a top surface of a device to which the phosphor is to be applied. However, since the wire is bonded to the top of the LED in the conventional light emitting device package shown in FIGS. 3a and 3b, it is not easy to apply the phosphor without damaging the wire.

Further, to perform the wire bonding, a device is fabricated considering a pattern area of a bonding pad. However, if a wire bonding portion comprising the bonding pad and the wire is placed on the top of the LED, a disadvantage occurs that it partially conceals a vertical light emitting area.

That is, although an area of about 0.1×0.1mm² is required for wire bonding, the wire bonding portion conceals 1/9 of a light emitting area in a chip of 0.3×0.3mm².

Further, tendency is that, in manufacturing a high-performance LED its entire area comes to be larger, and if necessary, the number of ohmic metal pads may be increased to reduce electrical resistance .

Since a high-performance LED is operated with a high current, it will be apparent that serial resistance should be reduced to prevent heat accumulation. Further, an ohmic contact metal is made thicker to reduce a voltage drop there by enhancing the light extraction efficiency. However, since there is limitation on deposit of a thick metal and the area of a wire bonding pad positioned on the top of an LED should be increased to prevent deterioration of the performance of the LED due to a voltage drop within the ohmic contact metal, a vertical light emitting area of the LED inevitably decreases.

US 4936808 A relates to a method of making a light-emitting-diode (LED) array head for use in semiconductor device manufacturing. US 2002/0171090 A1 relates to a method of fabricating a display device. JP 2005 057239 A relates to a method of coating a photosensitive film on a flip chip LED and patterning said film to control the directivity of light emitted by the flip chip LED.

### SUMMARY OF THE INVENTION

The present invention is defined by the claims. The present invention is conceived to solve the aforementioned problems. Accordingly, an object of the present invention is to provide a light emitting device package and a method for manufacturing the same, wherein a light emitting device is electrically connected to other devices without use of wire bonding so that a space for the wire bonding can be decreased to reduce the size of a package, and a short-circuit or disconnection caused by the wire bonding can be reduced to improve reliability of the package.
Another object of the present invention is to provide a light emitting device package and a method for manufacturing the same, wherein a light transmitting material film is coated on a substrate with a light emitting device mounted thereon so that an additional passivation film capable of protecting the light emitting device can be dispensed, and wire bonding is not required to enable reduced manufacturing costs and mass production.

A further object of the present invention is to provide a light emitting device package and a method for manufacturing the same, wherein a conductive interconnection portion is used without a wire at a light emitting device so that uniform application of a phosphor can be easily made and an area absorbing vertically emitted light can be reduced to improve light extraction of the device.

According to a first preferred aspect of the present invention for achieving the object, there is provided a light emitting device package, comprising : a substrate with a conductive pad formed thereon; a light emitting device mounted on the substrate and having an electrode pad formed on at least one of the top and bottom of the light emitting device; a light transmitting material film for surrounding the conductive pad and the light emitting device while exposing a portion of each of the conductive pad and the electrode pad formed on the at least one of the top and bottom of the light emitting device; and a conductive line formed along a surface of the light transmitting material film from the exposed portion of the conductive pad to the exposed portion of the electrode pad of the light emitting device, wherein the light transmitting material film is made of a photosensitive substance through which light can be transmitted.

According to a second preferred aspect of the present invention for achieving the object, there is provided a light emitting device package, comprising : a substrate with a pair of conductive pads formed thereon; a light emitting device mounted on the substrate and having a pair of electrode pads formed on the top of the light emitting device; a light transmitting material film for surrounding the conductive pads and the light emitting device while exposing a portion of each of the pair of conductive pads and a portion of each of the pair of electrode pads; and a pair of conductive lines formed along a surface of the light transmitting material film from the exposed portion of each of the pair of conductive pads to the exposed portion of each of the pair of electrode pads, wherein the light transmitting material film is made of a photosensitive substance through which light can be transmitted.

According to a fourth preferred aspect of the present invention for achieving the object, there is provided a method for manufacturing a light emitting device package, comprising : mounting a light emitting device having an electrode pad formed on at least one of the top and bottom of the light emitting device on a substrate with a conductive pad formed thereon; forming a light transmitting material film for surrounding the conductive pad and the light emitting device while exposing a portion of each of the conductive pad and the electrode pad formed on the at least one of the top and bottom of the light emitting device; and forming a conductive line formed along a surface of the light transmitting material film from the exposed portion of the conductive pad to the exposed portion of the electrode pad of the light emitting device, wherein the light transmitting material film is made of a photosensitive substance through which light can be transmitted.

According to a fifth preferred aspect of the present invention for achieving the object, there is provided a method for manufacturing a light emitting device package, comprising : bonding a light emitting device formed with a pair of electrode pads to a substrate with a pair of conductive pads formed thereon; forming a light transmitting material film for surrounding the conductive pads and the light emitting device while exposing a portion of each of the pair of conductive pads and a portion of each of the pair of electrode pads; and forming a pair of conductive lines formed along a surface of the light transmitting material film from the exposed portion of each of the pair of conductive pads to the exposed portion of each of the pair of electrode pads, wherein the light transmitting material film is made of a photosensitive substance through which light can be transmitted.

### BRIEF DESCRIPTION OF THE DRAWINGS

The above and other objects, features and advantages of the present invention will become apparent from the following description of preferred embodiments given in conjunction with the accompanying drawings, in which:
FIG. 1 is a sectional view of a conventional light emitting device package using wire bonding;
FIG. 2 is a sectional view showing a state where light emitting devices are arrayed and packaged according to a prior art;
FIGS. 3a and 3b are sectional views schematically showing a state where a phosphor is applied to a conventional light emitting device package;
FIG. 4 is a schematic sectional view of a light emitting device package according to a first embodiment not forming part of the claimed invention;
FIG. 5 is a sectional view of a light emitting device package having a non-conductive substrate applied thereto in accordance with the first embodiment not forming part of the claimed invention;
FIG. 6 is a sectional view of a light emitting device package having a conductive substrate applied thereto in accordance with a first embodiment according to the present invention;
FIGS. 7a to 7c are sectional views illustrating a process of manufacturing the light emitting device package according to the first embodiment not forming part of the claimed invention;
FIGS. 8a and 8b are sectional views illustrating an example of a process of forming a light transmitting material film;
FIGS. 9a and 9b are sectional views illustrating another example of a process of forming a light transmitting material film;
FIG. 10 is a schematic sectional view of a light emitting device package according to a second embodiment not forming part of the claimed invention;
FIGS. 11a to 11c are sectional views illustrating a process of manufacturing the light emitting device package according to the second embodiment not forming part of the claimed invention;
FIG. 12 is a sectional view showing a state where light emitting devices are arrayed and packaged;
FIG. 13 is a sectional view of a package for implementing a white light source by arraying light emitting devices not in accordance with the present invention;
FIG. 14 is a sectional view of another package for implementing a white light source by arraying light emitting devices not in accordance with the present invention;
FIG. 15 is a schematic sectional view showing a state where a phosphor is screen-printed on a light emitting device package according to a third embodiment not forming part of the claimed invention;
FIG. 16 is sectional view of another light emitting device package according to the third embodiment not forming part of the claimed invention;
FIG. 17 is a plan view of a conventional laser lift-off GaN-based light emitting diode (LED) with a wire bonding portion existing thereon;
FIGS. 18a to 18d are plan views showing a state where a conductive pad is positioned outside an LED portion according to the third embodiment not forming part of the claimed invention;
FIGS. 19a to 19d are schematic views illustrating a process of manufacturing a high-performance laser lift-off light emitting device package provided with an interconnection portion according to the third embodiment not forming part of the claimed invention; and
FIG. 20 is a graph illustrating an area ratio of a conductive pad to an entire area of a unit chip.

### DETAILED DESCRIPTION OF THE PREFERRED EMBODIMENTS

Hereinafter, preferred embodiments of the present invention will be described in detail with reference to the accompanying drawings.

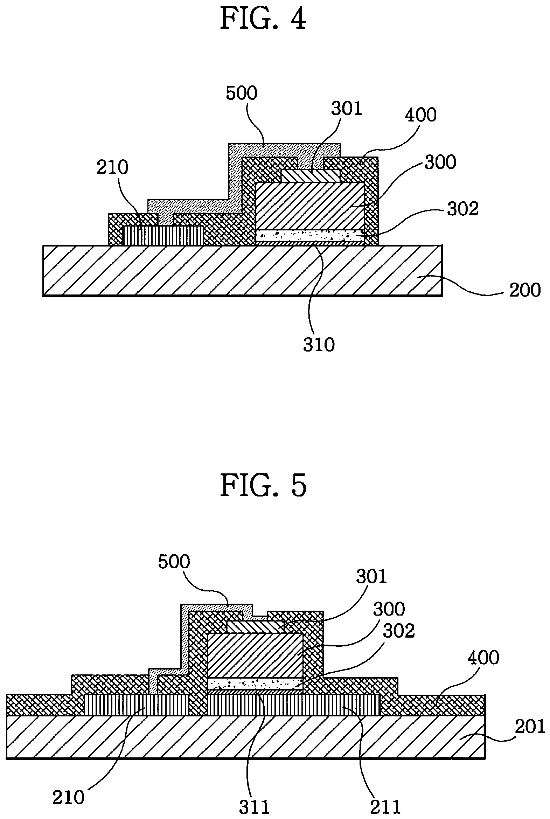

FIG. 4 is a schematic sectional view of a light emitting device package according to a first embodiment not forming part of the claimed invention. The light emitting device package comprises : a substrate (200) with a conductive pad (210) formed thereon; a light emitting device (300) that is mounted on the substrate (200) and has electrode pads (301, 302) respectively formed on the top and bottom of the light emitting device (300); a light transmitting material film (400) surrounding the conductive pad (210) and the light emitting device (300) while exposing a portion of each of the conductive pad (210) and the electrode pad (301) formed on the top of the light emitting device (300); and a conductive line (500) formed along a surface of the light transmitting material film (400) from the exposed portion of the conductive pad (210) to the exposed portion of the light emitting device (300).

Here, it is preferred that the light transmitting material film (400) be made of a photosensitive material through which light can be transmitted.

Preferably, the photosensitive material is a photosensitive material that can transmit almost all the light there through without absorbing red or infrared rays and is SU-8 polymer with superior thermal and chemical resistances.

Further, a phosphor capable of performing wavelength conversion of light emitted from the light emitting device (300) may be dispersed in the light transmitting material film (400).

In this case, light that is emitted from the light emitting device (300) and subjected to the wavelength conversion by the phosphor is mixed in color, thereby implanting a white light source.

Further, it is preferred that the light emitting device (300) having electrode pads (301, 302) respectively formed on the top and bottom thereof be a red or infrared light emitting device.

Meanwhile, the light emitting device (300) is mounted on the substrate (200) using an adhesive (310). The adhesive 310 is preferably a conductive paste or solder metal.

In addition, the substrate (200) comprises a semiconductor substrate made of a semiconductor such as silicone, a non-conductive substrate, or a conductive substrate made of a conductive material such as metal.

Further, it is preferred that the light emitting device (300) be a light emitting diode (LED) comprising a semiconductor layer with a first polarity, an active layer, and a semiconductor layer with a polarity opposite to the first polarity.

Furthermore, the light transmitting material film (400) exposes a portion of each of the conductive pad (210) and the electrode pad (301) formed on the top of the light emitting device (300). As shown in FIG. 4, the light transmitting material film (400) may be formed as a structure completely surrounding the conductive pad (210) and the light emitting device (300) or formed only in regions located along the shortest distance from the conductive pad (210) to the electrode pad (301).

Since both cases have their own advantage, the light transmitting material film may be freely designed.

Moreover, it is also preferred that the light transmitting material film (400) be formed on a portion of the light emitting device (300) and a phosphor film surrounding the light transmitting material film (400) and the light emitting device (300) be further provided.

FIG. 5 is a sectional view of a light emitting device package having a non-conductive substrate applied thereto in accordance with the first embodiment not forming part of the claimed invention. If the substrate used in the structure of FIG. 4 is substituted with a non-conductive substrate (201) as shown in FIG. 5, the light emitting device package has a structure in which another conductive pad (211) is formed on an upper region of the non-conductive substrate (201) spaced apart from a conductive pad (210) connected to an electrode pad (301) of a light emitting device (300) through a conductive line (500), and an electrode pad (302) formed beneath the light emitting device (300) is bonded to the other conductive pad (211) using a conductive adhesive (311).

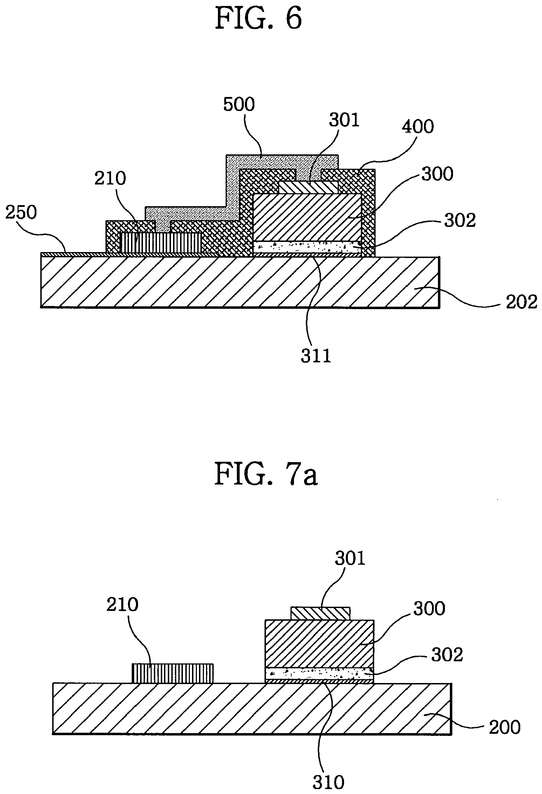

FIG. 6 is a sectional view of a light emitting device package having a conductive substrate applied thereto in accordance with a first embodiment according to the present invention.
If the substrate used in the structure of FIG. 4 is substituted with a conductive substrate (202), the light emitting device package has a structure in which an insulation film (250) is interposed between the conductive substrate (202) and a conductive pad (210) connected to an electrode pad (301) of a light emitting device (300) through a conductive line (500), and an electrode pad (302) formed beneath the light emitting device (300) is bonded to the conductive substrate (202) using a conductive adhesive (311).

FIGS. 7a to 7c are sectional views illustrating a process of manufacturing the light emitting device package according to the first embodiment not forming part of the claimed invention. First, a light emitting device (300) with electrode pads (301, 302) respectively formed on the top and bottom thereof is mounted on a substrate (200) with a conductive pad (210) formed thereon (FIG. 7a).

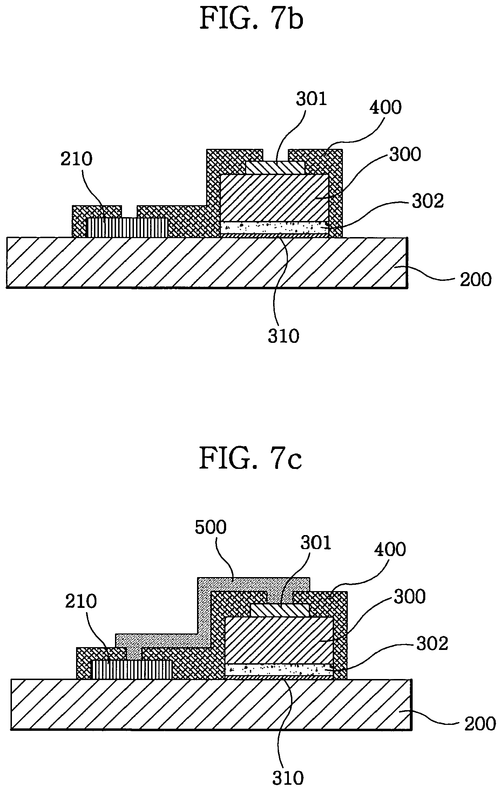

Thereafter, a light transmitting material film (400) surrounding the conductive pad (210) and the light emitting device (300) is formed while exposing a portion of each of the conductive pad (210) and the electrode pad (301) formed on the top of the light emitting device (300) (FIG. 7b).

As will be described later, the light transmitting material film (400) is formed by performing a process of coating a light transmitting material on the conductive pad (210) and the light emitting device (300) to form a film and selectively removing the film to expose the portions of the conductive pad (210) and the electrode pad (301) formed on the top of the light emitting device (300).

Subsequently, the conductive line (500) is formed along a surface of the light transmitting material film (400) from the exposed portion of the conductive pad (210) to the exposed portion of the electrode pad (301) of the light emitting device (300) (FIG. 7c).

Here, the conductive line (500) is formed when the exposed portions of the conductive pad (210) and the electrode pad (301) formed on the top of the light emitting device (300) are connected to each other using a conductive material.

The conductive line (500) should make a connection with a uniform thickness to decrease tolerance in view of internal resistance or the like.

Therefore, the conductive pad (210) and the electrode pad (301) of the light emitting device (300) are connected to each other using the conductive material through a lift-off or hard mask technique.

In the lift-off technique, when the light transmitting material film (400) is made of a photosensitive material and the light transmitting material film (400) is selectively etched using an appropriate liquid solution after a conductive material has been deposited on the light transmitting material film (400), the conductive material in which the light transmitting material film (400) has been etched is lifted off and removed.

Therefore, the conductive pad (210) and the electrode pad (301) of the light emitting device (300) are connected to each other through the conductive material by means of the lift-off technique.

Further, in the hard mask technique, a fixed frame is formed to connect the conductive pad (210) and the electrode pad (301) of the light emitting device (300) to each other through a conductive material, and the conductive material is then sprayed onto the formed frame.

Therefore, the conductive pad (210) and the electrode pad (301) of the light emitting device (300) are connected to each other through the conductive material by means of the spraying.

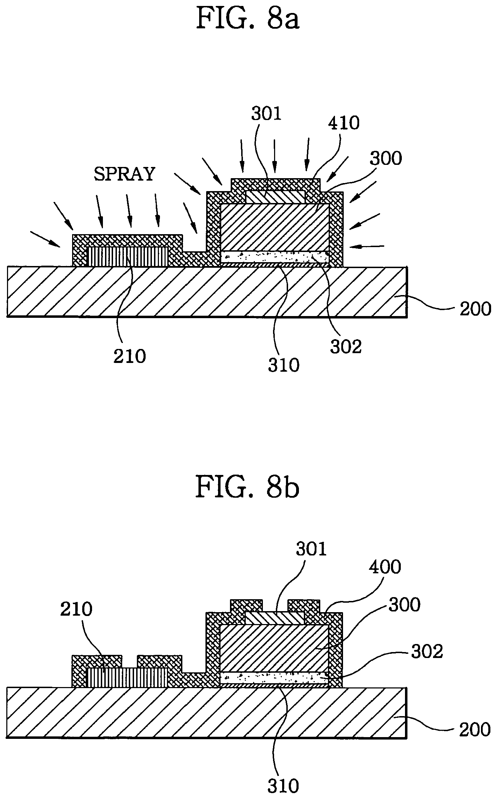

FIGS. 8a and 8b are sectional views illustrating an example of a process of forming a light transmitting material film. To form the light transmitting material film (400) as shown in Fig 7b, a light transmitting material is first coated on a substrate (200) while surrounding the conductive pad (210) and the light emitting device (300).

A film formed through coating of a light transmitting material is defined as a coating film (410).

Further, when the light transmitting material is coated, a spray coating technique is used as shown in FIG. 8a.

The spray coating technique is a technique capable of performing uniform coating in a case where there is a large step in a substrate.

That is, when the light emitting device (300) is bonded to the substrate (200), the height of a portion of the substrate to which the light emitting device (300) is bonded is remarkably high as compared with that of a portion of the substrate to which the light emitting device (300) is not bonded.

Therefore, although it is considerably difficult to uniformly coat the light transmitting material on an entire surface of the substrate (200), the spray coating technique enables the light transmitting material to be coated with a uniform thickness on a structure where there is a large step therein, thereby reducing tolerance in view of internal resistance.

Thereafter, the coating film (410) is patterned to expose a portion of each of the conductive pad (210) and the electrode pad (301) formed on the top of the light emitting device (300) (FIG. 8b).

Thus, the light transmitting material film (400) shown in FIG. 7b is formed through the processes of FIGS. 8a and 8b.

Meanwhile, the patterning is preferably made through a photolithography process.

At this time, if the light transmitting material film (400) is a photosensitive material, the photolithography process can be more easily performed.

For example, a mask is formed on an upper surface of the photosensitive material and light is radiated thereon. Then, a portion of the photosensitive material on which light is radiated or not radiated can be easily removed using a substance of acetone or the like in accordance with the property of the photosensitive material.

That is, the portions of the conductive pad (210) and the electrode pad (301) of the light emitting device (300) are exposed by means of the etching.

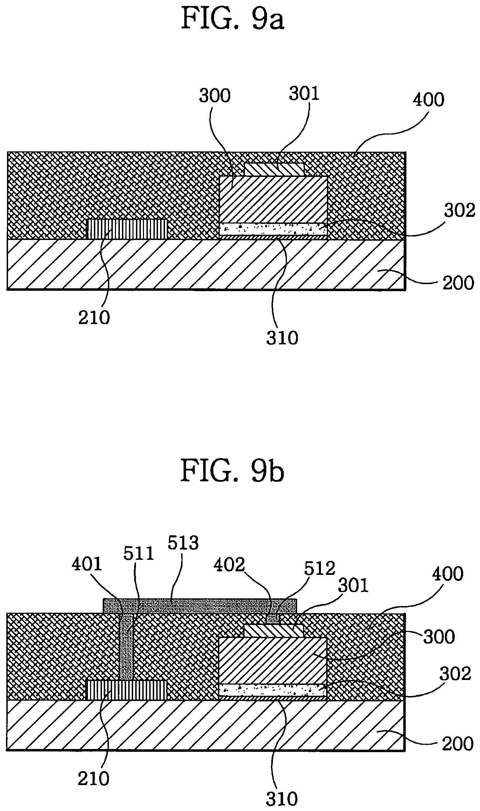

FIGS. 9a and 9b are sectional views illustrating another example of a process of forming a light transmitting material film. A light transmitting material film may be formed according to the shapes of a conductive pad and a light emitting device as shown in FIG. 8a. Otherwise, a flat film of which the top is flattened is formed while surrounding the conductive pad (210) and the light emitting device (300), thereby facilitating formation of a conductive line.

That is, in this method, after the process of FIG. 7a, the light transmitting material film (420) of which the top is flattened and which surrounds the conductive pad (210) and the light emitting device (300) is formed (FIG. 9a).

Then, a pair of trenches (401, 402) are formed by removing portions of the light transmitting material film (400) from the top of the light transmitting material film (400) to the conductive pad (210) and the electrode pad (301) of the light emitting device (300), conductive materials (511, 512) are respectively filled in the pair of trenches (401, 402), and a process of forming a conductive layer (513) connecting the conductive materials (511, 512) is performed (FIG. 9b).

Thus, the conductive line comprises the conductive materials (511, 512) respectively filled in the pair of trenches (401, 402), which have been formed by removing the portions of the light transmitting material film (400) from the top of the light transmitting material film (400) to the conductive pad (210) and the electrode pad (301) of the light emitting device (300); and the conductive layer (513) formed on the light transmitting material film (400) to connect the conductive materials (511, 512) to each other filled in the pair of trenches (401, 402).

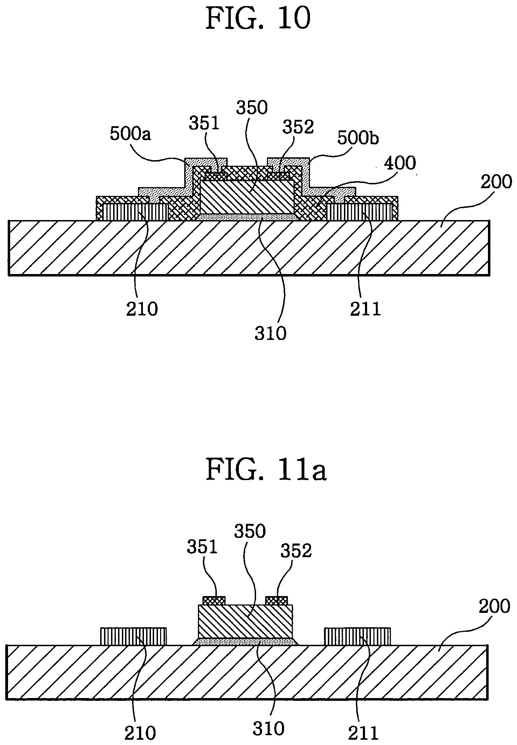

FIG. 10 is a schematic sectional view of a light emitting device package according to a second embodiment. The light emitting device package of the second embodiment comprises a substrate (200) with a pair of conductive pads (210, 211) formed thereon; a light emitting device (350) mounted on the top of the substrate (200) and having a pair of electrode pads (351, 352) formed thereon; a light transmitting material film (400) for surrounding the conductive pads (210, 211) and the light emitting device (350) while exposing portions of the pair of conductive pads (210, 211) and portions of the pair of electrode pads (351, 352); and a pair of conductive lines (500a, 500b) formed along a surface of the light transmitting material film (400) from the exposed portions of the pair of conductive pads (210, 211) to the exposed portions of the pair of electrode pads (351, 352), respectively. In a second embodiment according to the invention, the substrate (200) is a conductive substrate, and an insulation film is interposed between the conductive pads (210, 211) and the substrate (200).

Further, it is preferred that the light emitting device (350) be a green or blue light emitting device.

FIGS. 11a to 11c are sectional views illustrating a process of manufacturing the light emitting device package according to the second embodiment not forming part of the claimed invention. As shown in FIG. 11a, a light emitting device (350) with a pair of electrode pads (351, 352) formed thereon is bonded to the top of a substrate (200) with a pair of conductive pads (210, 211) thereon.

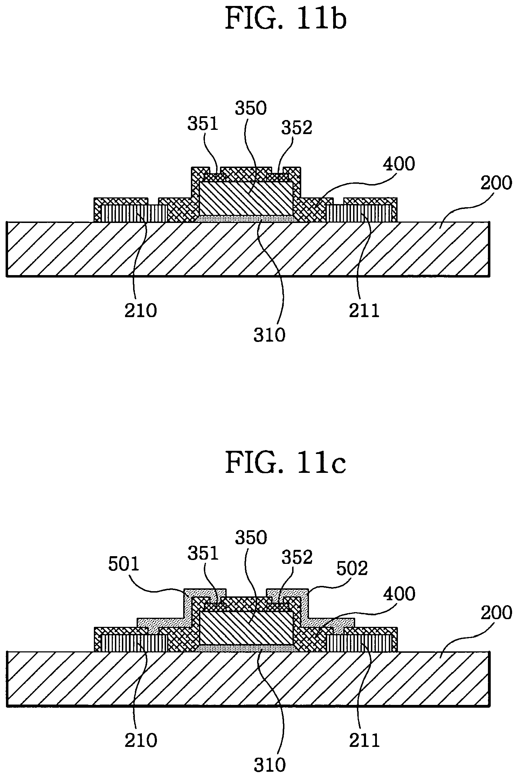

Then, a light transmitting material film (400) surrounding the conductive pads (210, 211) and the light emitting device (350) is formed while exposing portions of the pair of conductive pads (210, 211) and portions of the pair of electrode pads (351, 352) (FIG. 11b).

Finally, a pair of conductive lines (501, 502) are formed along a surface of the light transmitting material film (400) from the exposed portions of the pair of conductive pads (210, 211) to the exposed portions of the pair of electrode pads (351, 352), respectively (FIG. 11c).

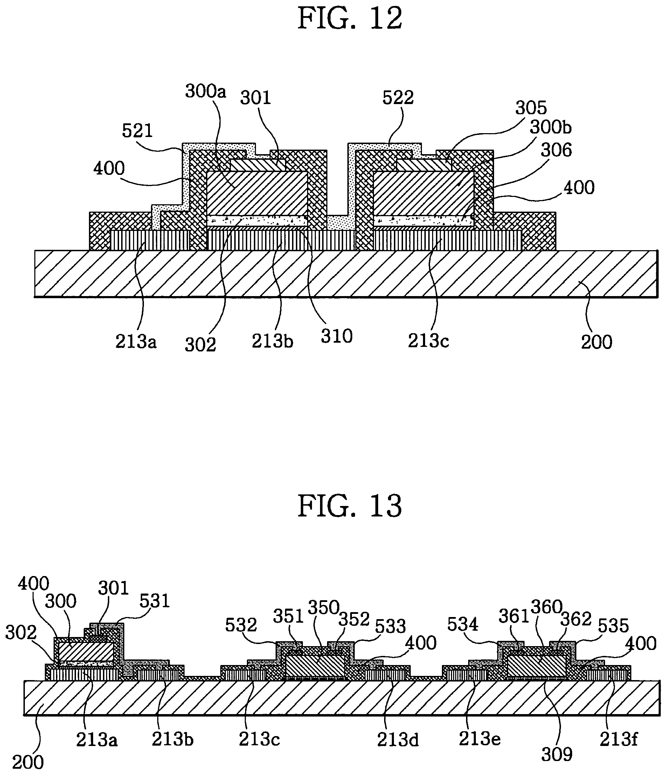

FIG. 12 is a sectional view showing a state where light emitting devices are arrayed and packaged. A plurality of light emitting devices (300a, 300b) with electrode pads (301, 302; 305, 306) formed respectively on the top and bottom thereof are bonded to correspond to a plurality of conductive pads (213b, 213c).

At this time, the light emitting devices (300a, 300b) are not bonded to a conductive pad (213a), and a light transmitting material film (400) surrounds the conductive pads (213a, 213b, 213c) and the light emitting devices (300a, 300b) while exposing portions of the conductive pads (213a, 213b, 213c) and the electrode pads (301, 305) formed respectively on the tops of the light emitting devices (300a, 300b).

Further, a conductive line (521) for connecting the conductive pad (213a) to which the light emitting devices (300a, 300b) are not bonded to the electrode pad (301) of the light emitting device (300a) adjacent thereto is formed along a surface of the light transmitting material film (400), and a conductive line (522) for connecting the electrode pad (213b) with the light emitting device (300a) bonded thereto to the electrode pad (305) of the other light emitting device (300b) is formed along a surface of the light transmitting material film (400).

Therefore, it is possible to implement a package in which two light emitting devices are connected in parallel without using a wire bonding technique.

FIG. 13 is a sectional view of a package for implementing a white light source by arraying light emitting devices. One light emitting device (300) with electrode pads (301, 302) formed respectively on the top and bottom thereof is packaged on a substrate (200) in the same manner as the first embodiment.

Further, two light emitting devices (350, 360) each of which has a pair of electrode pads (351, 352; 361, 362) formed thereon are packaged in the same manner as the second embodiment.

The light emitting device 300 with the electrode pads (301, 302) formed respectively on the top and bottom thereof is a red light emitting device, and the light emitting devices (350, 360) each of which has the pair of electrode pads (351, 352; 361, 362) formed thereon are green and blue light emitting devices.

Thus, it is possible to implement a package capable of emitting white light, wherein red, green and blue light emitting devices are mounted on a substrate and these light emitting devices are electrically connected to one another without wire bonding.

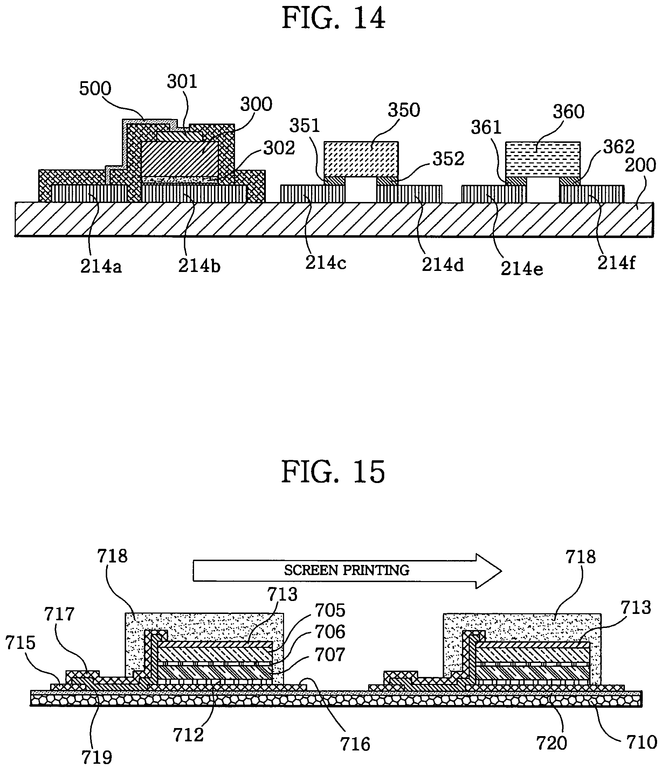

FIG. 14 is a sectional view of another package for implementing a white light source by arraying light emitting devices. Six conductive pads (214a, 214b, 214c, 214d, 214e, 214f) are formed on a substrate (200), and a light emitting device (300) with electrode pads (301, 302) formed respectively on the top and bottom thereof is mounted on the substrate (200) using the two conductive pads (214a, 214b) and then packaged without wire bonding.

Two light emitting devices (350, 360) each of which has a pair of electrode pads (351, 352; 361, 362) formed on the bottom thereof are flip-chip boned to the remaining four conductive pads (214c, 214d, 214e, 214f).

Therefore, the three light emitting devices are packaged without using wires. If the two light emitting devices (350, 360), which are flip-chip bonded to the conductive pads, are green and blue light emitting devices, respectively, and the light emitting device (300), which is not flip-chip bonded, is a red light emitting device, it is possible to implement a package capable of emitting white light.

The following embodiment is a third embodiment not forming part of the claimed invention. A light emitting device package comprising a light emitting device; a conductive pad positioned outside the light emitting device and electrically connected to an external power source; and one or more interconnection portions for connecting the conductive pad to one or both faces of the light emitting device, and a method for manufacturing the light emitting device package will be described below.

It is apparent that a package is also manufactured without wire bonding in the third embodiment of the present invention.

FIG. 15 is a schematic sectional view showing a state where a phosphor is screen-printed on a light emitting device package according to a third embodiment not forming part of the claimed invention. If a package in which a plurality of light emitting devices are mounted on a substrate and each of the light emitting devices is connected to a conductive pad through an interconnection portion (717) is formed, there is an advantage in that phosphors (718) can be applied at a time by means of screen printing as shown in FIG. 15, thereby reducing manufacturing costs and enabling mass production.

In addition, reference numeral "719" in FIG. 15 designates a transparent insulation film and is made of a material identical with or different from that of the light transmitting material film in the first and second embodiments.

Further, an insulation material that is substantially transparent with the naked eye and light can be transmitted therethrough is preferably formed into the transparent insulation film (719) in the third embodiment of the present invention.

Furthermore, in the third embodiment not forming part of the claimed invention, the transparent insulation film is formed along a side of the light emitting device and according to the shape of an insulation film (720) formed on a substrate (710) from a portion of an n-ohmic contact metal layer(713), which is an upper electrode of the light emitting device, to an n-type conductive pad (715) formed on the substrate (710) as shown in FIG. 15.

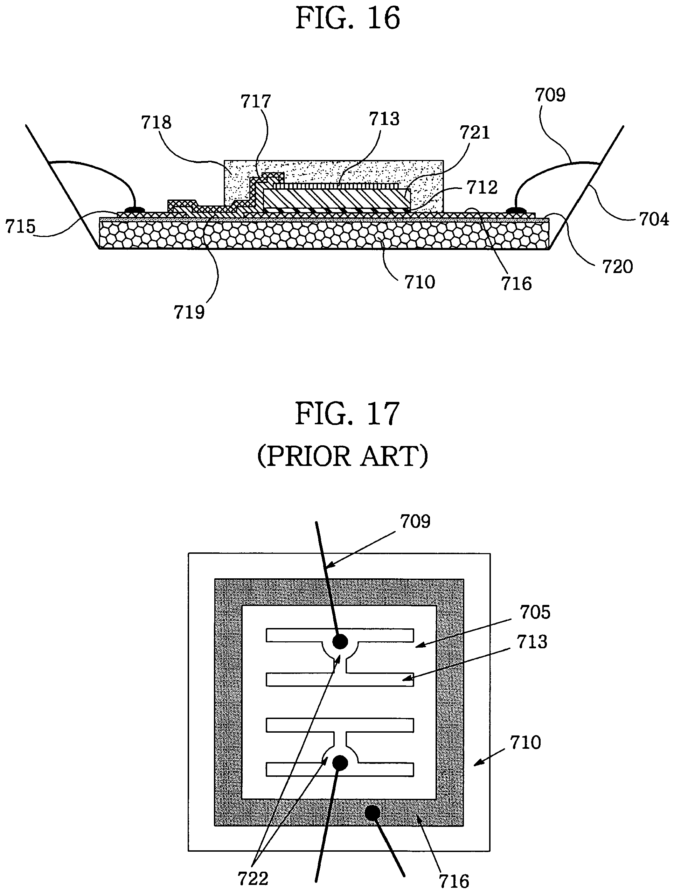

FIG. 16 is sectional view of another light emitting device package according to the third embodiment not forming part of the claimed invention. A pair of conductive pads, e.g., an n-type conductive pad (715) and a p-type conductive pad (716), exist on an insulation film (720) formed in a plane of a substrate (710); and a p-type layer, an active layer and an n-type layer of an LED are sequentially formed into a stack structure on the p-type conductive pad (716).

At this time, a p-ohmic contact metal layer (712) is bonded to a surface of the p-type conductive pad adjacent to the p-type layer.

A substrate generally known in the art may be used as a substrate (710) with the LED mounted thereon, and the substrate may be made of CuW, Si, AlN ceramic, Al₂O₃ ceramic or the like.

The size of the substrate may be larger than that of the LED, or larger than or identical with a sapphire substrate in a case where the LED is grown on the sapphire substrate.

The LED may be formed by sequentially laminating the p-type layer (707), the active layer (706) and the n-type layer (705) using a III-V group compound generally known in the art as shown in FIG. 15, and nonlimiting examples of the compound include GaAs, GaP, GaN, InP, InAs, InSb, GaAlN ,InGaN, InAlGaN and a mixture thereof.

Further, although the p-type and n-type layers may not be doped with p-type and n-type dopants, they are preferably doped with the dopants.

Furthermore, the active layer may be of a single quantum well or multiple quantum well (MQW) structure.

The LED may comprise another buffer layer in addition to the aforementioned p-type layer, active layer and n-type layer.

LEDs with a long wavelength to a short wavelength can be fabricated freely by adjusting the component of the III-V group compound. Accordingly, the present invention is not limited to a blue nitride-based LED with a wavelength of 460nm but may be applied to all LEDs.

An insulation film is formed on a connection path between the n-ohmic contact metal layer(713) deposited on the uppermost layer of the LED and the n-type conductive pad (715) positioned outside the LED, and the interconnection portion for electrically connecting the n-ohmic contact metal layer(713) to the n-type conductive pad (715) is formed on the insulation film.

Such a pair of conductive pads (715, 716) are electrically connected to a lead frame that is in turn connected to an external power source.

The light emitting device package configured as above can be operated according to a principle that will be described below.

That is, when a specific voltage is applied between the pair of conductive pads (715, 716) through wires (709) connected to the external power source, a cathode is connected through the n-type conductive pad (715), the interconnection portion (717), the n-type ohmic contact metal layer(713) and the n-type layer, and an anode is connected through the p-type conductive pad (716), the p-type ohmic contact metal layer(712) and the p-type layer so that a current can flow.

Accordingly, while electrons and holes are being recombined in the active layer, light corresponding to a bandgap or an energy level difference of the active layer is emitted.

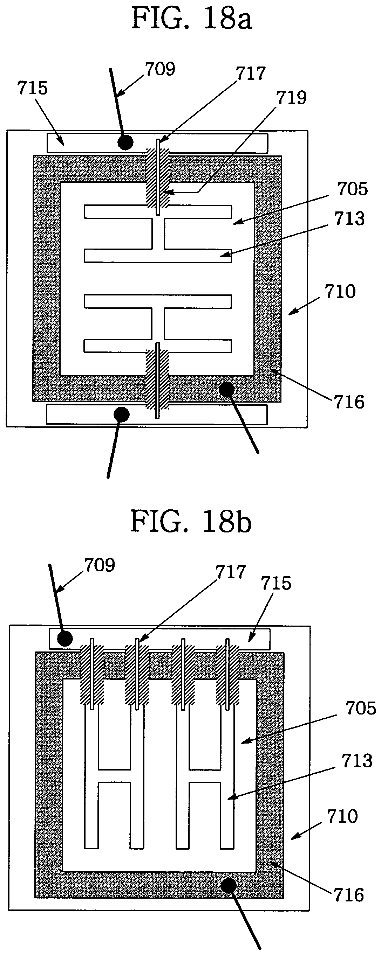

Meanwhile, the interconnection portion (717) and a connection portion connected thereto, e.g., arrangement of the n-ohmic contact metal layer (713), the n-type conductive pad (715) and the p-type conductive pad (716), in the LED according to the present invention will be described with reference to FIGS. 17 and 18a to 18d.

FIG. 17 is a plan view of a conventional LED with wire bonding portions (722) existing thereon.

It can be seen that there is a problem in that a vertical light emitting area is partially concealed due to the wire bonding portions existing on the LED as described above.

On the contrary, FIGS. 18a to 18d show a case where a conductive pad and a surface of an LED according to the present invention, preferably, a conductive pad and the ohmic contact metal layer (713) formed on the LED are electrically connected to each other through the interconnection portion (717).

Actually, with the presence of the conductive pad outside the LED, a vertical light emitting area can be maximized, and it can also be expected that control of the number, location and the like of interconnection portions enables easiness of a manufacturing process, improvement of light extraction efficiency and the like. Descriptions thereof will be made as follows.

FIG. 18a is a top plan view of a light emitting device, showing a case where a conductive pad is positioned outside the LED in accordance with the third embodiment not forming part of the claimed invention. This figure shows a case where ohmic contact metals are deposited as two patterns that are not connected to each other on an n-type layer (705), transparent insulation films (719) are formed on connection paths of interconnection portions (717) for connecting the ohmic contact metal and conductive pads to each other, and the interconnection portions (717) are placed at opposite sides of the ohmic contact metals of the respective patterns.

Here, conductive pads connected to the interconnection portions (717) are n-type conductive pads (715) in FIG. 18a, reference numeral "710" in FIG. 18a designates a substrate, and reference numeral 716 designates a p-type conductive pad.

At this time, the width of a wire (709) is about 25*µ*m. If the diameter of a ball produced in wire bonding is about 100*µ*m, the conductive pad on which the ball is produced, e.g., the n-type pad (715), should have a size of at least 100×100*µ*m.

If a wire bonding portion exists on the top of an LED as in the prior art, an area of at least 100×100*µ*m shields vertical light emission. On the contrary, since a much smaller area is consumed in the LED using the interconnection portions (717) according to the present invention, a light shielding area is decreased.

FIG. 18b shows a modification example not forming part of the claimed invention, and is a plan view showing a case where ohmic contact metal layers are deposited as two patterns that are not connected to each other on an n-type layer (705), transparent insulation films (719) are formed on connection paths of interconnection portions (717) for connecting the ohmic contact metal and a conductive pad to each other, and the interconnection portions (717) are placed at one sides of the ohmic contact metals of the respective patterns.

If the conductive pad is positioned at one side rather than opposite sides as described above, a spatial margin can be greatly reduced in a process of arranging a conductive pad and a unit chip, thereby facilitating an operation.

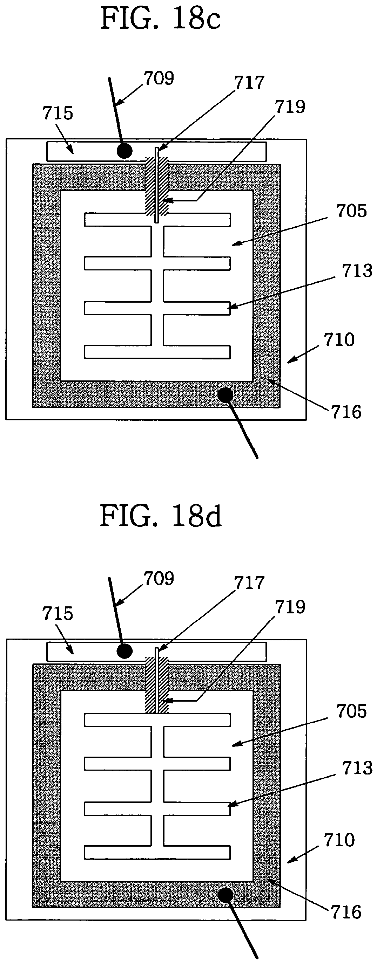

Further, if one interconnection portion (717) is used, light may be non-uniformly distributed due to a voltage drop in a case where the resistance of an n-ohmic contact metal (713) is large. On the contrary, the use of a plurality of interconnection portions (717) can exhibits an advantage of prevention of the non-uniform distribution of light. FIG. 18c shows another modification example not forming part of the claimed invention, and is a top plan view showing a case where an ohmic contact metal layer is formed of one pattern on an n-type layer (705) and the ohmic contact metal layer and only one interconnection portion (717) are formed.

In a case where the upper area of an LED is small, it is desirable to reduce a concealed area by decreasing the number of interconnection portions (717). Thus, a device should be driven by depositing an n-ohmic contact metal (713) with a sufficiently large thickness.

To this end, the n-ohmic contact metal layer(713) should be formed to define a unit.

When the resistance of a metal itself is small, a voltage drop is small so that a device can be driven with a desired current. Thus, the n-ohmic contact metal layer(713) should be deposited with a sufficiently large thickness.

However, since a high-performance LED has a larger upper area, there is limitation on prevention of a voltage drop in driving the LED using only one interconnection portion (717) even though the n-ohmic contact metal layer(713) is deposited to have a larger thickness.

Therefore, it is preferred that two or more interconnection portions (717) be formed and the interconnection portions (717) and the n-ohmic contact metal layer(713) be arranged such that the upper area is concealed as little as possible.

FIG. 18d shows a further modification example, and is a plan view showing a case where before deposition of an ohmic contact metal, a transparent insulation film (719) is formed on a connection path between an interconnection portion for connecting an ohmic contact metal layer and a conductive pad, and the interconnection portion (717) and the ohmic contact metal layer are simultaneously formed. If the interconnection portion (717) and the ohmic contact metal layer are simultaneously formed in this manner, process steps are simplified, resulting in an advantage of cost reduction.

Here, the ohmic contact metal layer refers to the n-ohmic contact metal layer(713) in FIG. 18d.

The light emitting device package according to the third embodiment not forming part of the claimed invention does not have limitations on a manufacturing method, an output method and the wavelength range of emitted light.

Thus, although a light emitting device package of the present invention may be manufactured according to a variety of methods, a method for manufacturing the light emitting device package according to the third embodiment not forming part of the claimed invention may comprise the steps of: (a) forming at least one conductive pad on a substrate; (b) bonding a fabricated LED on the substrate; and (c) forming at least one conductive interconnection portion for electrically connecting one or both faces of the LED to the conductive pad.
1) At least one, preferably two or more conductive pads are first bonded or deposited at properly selected locations on a substrate such as a submount.
2) An LED in which an n-type layer, an active layer and a p-type layer are laminated on a first substrate such as a sapphire substrate is bonded to a second substrate.
   At this time, in case of a low output LED, it is bonded while the laminated order of an LED portion is maintained in a state where the first substrate is adjacent to the second substrate.
   Further, in case of a high output or laser lift-off type LED device, it is bonded in a state where an LED portion is inverted, i.e., the surface of the LED portion is bonded to a front surface of the second substrate.
   Furthermore, in case of a low output LED device, an LED portion is bonded in a state where it is grown on the first substrate, e.g., a sapphire substrate. In case of a laser lift-off type LED device, an LED portion grown on a sapphire substrate is bonded in reversed order and the sapphire substrate is then separated by means of laser irradiation.
   Thus, the sapphire substrate does not exist within a final LED device.
   As for a substance available upon bonding of an LED to the second substrate, the substance should supply a current to the LED and easily dissipate heat generated from the LED therethrough. Thus, a substance that can be easily bonded at a low temperature of 300°C or less may be used without limitation. Nonlimiting examples thereof include AuSn, AgSn, PbSn, Sn, silver paste, and the like.
3) To electrically connect the conductive pad and an ohmic contact metal layer formed on one or both faces of the LED, preferably the surface of the LED, which exist in the same plane on the second substrate, at least one interconnection portion made of a conductive metal is formed by means of thin film deposition patterning.

For reference, it is proper to form a transparent insulation film on the same connection path as the interconnection portion before the formation of the interconnection portion, and to cause the width of the insulation film to be equal to or greater than that of the interconnection portion.

At this time, convex and concave portions may be formed on the surface of the LED so that a large amount of light can escape therefrom by increasing a total reflection angle.

Further, in a case where an ohmic contact metal is deposited on the surface of the LED, one or two or more discrete patterns may be formed as shown in FIGS. 18a to 18d.

Furthermore, the ohmic contact metal may be implemented using not only a photolithography process but also a shadow mask, and these implementation techniques can be appropriately selected depending on the width of a wire.

In the light emitting device package provided with at least one interconnection portion according to the third embodiment not forming part of the claimed invention, the steps of performing wire bonding for connecting a conductive pad to an external power source, e.g., a lead frame and then applying a phosphor solely or a mixture with a phosphor and a molding material mixed therein may be performed in this order or vise versa.

Further, after the steps have been performed, the LED bonded to the second substrate may be separated into unit chips, or an LED separated into unit chips may be bonded to the second substrate.

Such a unit chip separation step is not limited to the foregoing but may be appropriately arranged in consideration of a user's intention or easiness of a manufacturing process.

Meanwhile, another method for manufacturing the light emitting device package using an interconnection portion according to the third embodiment of the present invention may include a laser lift-off (LLO) method.

As an example thereof, the method may comprise the steps of: (a) depositing a p-ohmic contact metal on a p-type layer of an LED grown on a first substrate; (b) processing a rear surface of the first substrate; (c) separating the first substrate on which the LED has been grown into unit chips; (d) bonding a surface of the p-ohmic contact metal layer of each of the unit chips obtained through the separation of the first substrate to a first conductive pad of two or more conductive pads formed on a second substrate; (e) irradiating a laser on a substrate surface of each of the unit chips bonded to the second substrate to remove the first substrate; (f) depositing an n-ohmic contact metal on an n-type layer of the LED exposed while the first substrate is being removed; (g) forming an insulation film on a path connecting a surface of the n-ohmic contact metal and a second conductive pad positioned on the second substrate, and forming at least one conductive interconnection portion for connecting the surface of the n-ohmic contact metal and the second conductive pad ; and (h) wire bonding each of the first and second conductive pads to an external power source, and applying a phosphor or performing treatment with a molding material having the phosphor mixed therein.

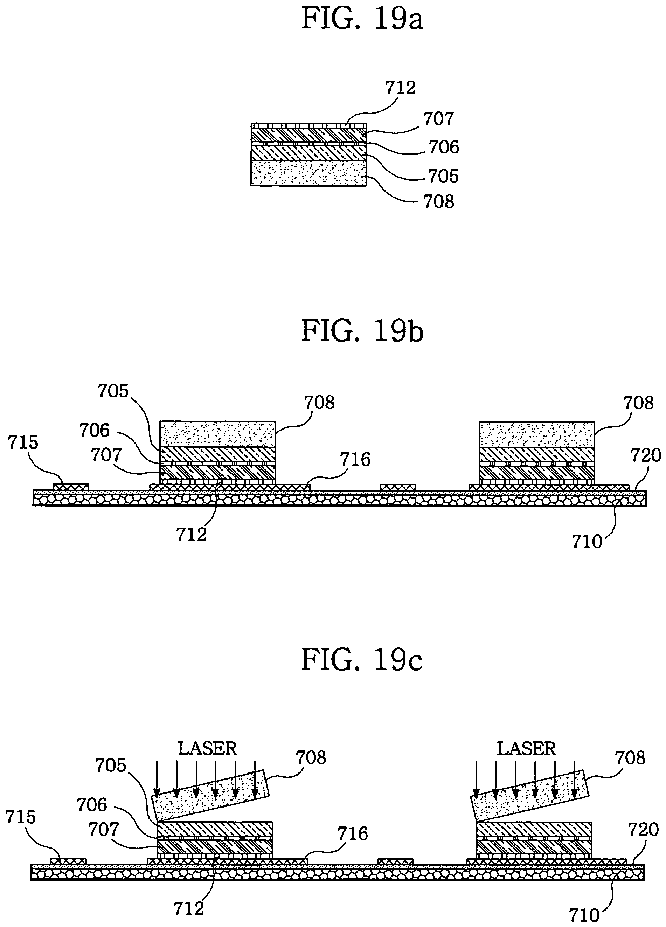

At this time, FIGS. 19a to 19d show a portion of processes of manufacturing the laser lift-off LED, wherein a first substrate, e.g., a sapphire substrate, is entirely bonded to a second substrate and the sapphire substrate is then removed by means of laser irradiation. The respective processes are as follows.

### (1) P-type ohmic contact formation (see FIG. 19a)

A wafer in which an LED, e.g., a GaN based LED crystal structure, has been grown on a sapphire substrate (708) is initially cleaned. Then, a p-type ohmic contact metal is formed on an upper p-type GaN surface of the wafer by means of vacuum deposition, and heat treatment is performed to complete a p-type ohmic contact metal.

### (2) Polishing treatment of surface of sapphire substrate

To form a mirror surface enabling laser light to easily transmit the sapphire substrate, a surface of the sapphire substrate with a thickness of about 430*µ*m is polished such that the thickness of the sapphire substrate is about 80 to 100*µ*m.

### (3) Unit chip formation

Before the sapphire substrate is bonded to or separated from a submount substrate, it is separated into unit chips through scribing/breaking treatment.

(4) Bonding of submount substrate (see FIG. 19b) In case of a high output LED, a submount substrate is used to enhance heat dissipation efficiency. At this time, an insulation film (720) is deposited on a substrate (710) to prevent a short, and conductive pads, e.g., an n-type conductive pad (715) and a p-type conductive pad (716), are formed on the insulation film (720).

The unit chip in which the sapphire substrate has been polished is inverted such that the sapphire substrate faces upward, and a surface of the p-type ohmic contact metal of the LED is boned to the submount substrate or the p-type conductive pad thereon using an adhesive.

When the unit chips are bonded to the substrate (710), it is preferred that they be periodically arranged at an interval of about a few hundred micrometers therebetween in consideration of a subsequent dicing process for the substrate (710) (see FIG. 19b).

### (5) Laser irradiation (see FIG. 19c)

A laser is irradiated onto the sapphire substrate surface of each of the chips to remove the sapphire substrate.

If a laser is irradiated, a laser beam that has transmitted the sapphire substrate is absorbed by a light emitting portion, e.g., GaN, and GaN at an interface between the sapphire and GaN is decomposed. Thus, metal gallium and nitrogen gas are produced so that the sapphire substrate can be separated from the LED crystal structure.

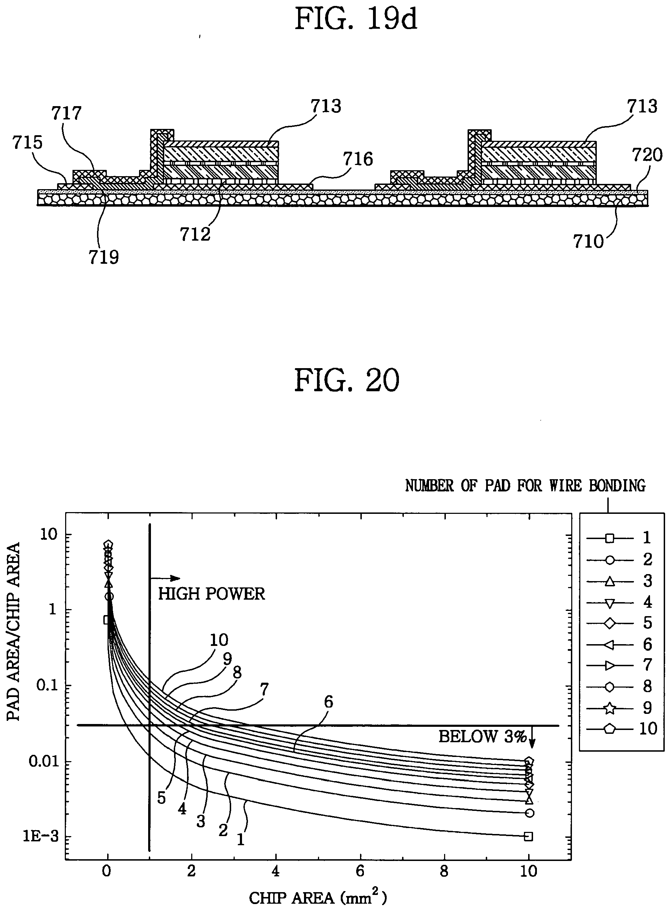

### (6) Formation of n-type ohmic contact metal (see FIG. 19d)

A polishing or dry (or wet) etching process is performed on a surface of the n-type layer, preferably n-GaN, exposed while the sapphire substrate is being removed, if necessary, and the n-type ohmic contact metal (713) is then deposited thereon.

At this time, the metal gallium produced upon decomposition of GaN exists on the surface of the exposed GaN.

Since such a metal gallium layer on the surface reduces light emitted from the LED, it is removed with hydrochloric acid, and an undoped-GaN layer is then etched to expose an n⁺-GaN layer by performing a dry (or wet) etching process if necessary. If necessary, a metal (e.g., Ti/Al based metal) for n-ohmic contact formation may be vacuum deposited.

### (7) Formation of interconnection portion

A transparent insulation film is formed on a connection path between the exposed n-type layer that is the uppermost layer of the LED and the n-type conductive pad positioned on the conductive substrate, preferably between the n-ohmic contact metal layer and the n-type conductive pad, at least one interconnection portion is then formed through deposited thin film patterning using a conductive metal.

### (8) Wire bonding and molding material treatment (phosphor application)

To connect the n-type conductive pad to an external power source, e.g., a lead frame, gold wire bonding is performed. Likewise, the p-type conductive pad is also connected to the external power source through wire bonding.

At this time, the connection of the n-type conductive pad to the external power source may be made by means of thin film deposition patterning.

### (9) Phosphor application or molding material treatment

Thereafter, a molding material such as epoxy or a material with a phosphor mixed therein is applied to complete manufacture of an LED package. Steps (8) and (9) may be performed in reverse order, if necessary.

Although the above description has been made in connection with a high output LED, the present invention may be applied to a low output LED.

As an example of a method for manufacturing a light emitting device package having such a low output LED applied thereto, the method may comprise the steps of: (a) etching an LED grown on a first substrate to expose an n-type layer of the LED and depositing an n-ohmic contact metal thereon; (b) depositing a p-ohmic contact metal on a p-type layer that is at the top of the LED; (c) processing a surface of the first substrate and separating the first substrate into unit chips; (d) bonding the first substrate surface of each of the separated unit chips on a second substrate formed with a conductive pad portion; (e) forming an insulation film on a path connecting a surface of the p-ohmic contact metal and the conductive pad portion positioned on the second substrate, and forming at least one conductive interconnection portion connecting the surface of the p-ohmic contact metal to the conductive pad portion ; and (f) wire bonding the conductive pad portion to an external power source and applying a phosphor or performing molding material treatment with the phosphor mixed therein.

At this time, the step of separating the first substrate into the unit chips may be performed in properly changed order to promote easiness of a manufacturing process and simplification of a process.

The methods for manufacturing the light emitting device package according to the third embodiment not forming part of the claimed invention are merely preferred manufacturing examples.

The light emitting device of the present invention includes a typical LED known in the art, e.g., a blue GaN based LED, as well as other light emitting devices capable of emitting light of all wavelengths. Preferably, the light emitting device is a white LED device for which phosphor application is required.

Further, the methods can be applied to all LED devices including low output type LED devices, high output flip type LED devices, and LED devices manufactured through a laser lift-off technique or other techniques.

Furthermore, the present invention provides a method of manufacturing a light emitting device package according to the claims. The light emitting apparatus includes all light emitting apparatuses having an LED device, such as lighting apparatuses, indicators, bactericidal lamps, and displays.

FIG. 20 is a graph illustrating an occupation ratio of the area of a wire bonding pad depending on changes in the area of a chip. This figure shows calculation results of the shielded amount of vertically emitted light when a wire bonding pad exists on the top of an LED.

In FIG. 20, since there is little difference between the area of a wire shielding vertically emitted light when wire bonding is performed directly on the top of an LED and the shielding area of an interconnection portion in case of a structure using the interconnection portion, the difference of the two factors is not considered.

The number of wire bonding pads (conductive pads) varies from 1 to 10, and conditions in which an area ratio of a pad to an entire area is less than 3% and a chip has an area of 1×1mm² or more, which is generally applied to a high output LED, are considered.

In a 1×1mm² chip, if the number of pads is 3 or less, the area ratio of less than 3% is satisfied. If the number of pads is 4 or more, the area ratio becomes 3% or more.

Actually, in a 1×1mm² chip, two bonding pads allow current driving to be sufficiently performed in the arrangement of the ohmic contact metal shown in FIG. 18a, and the condition of the area ratio of less than 3% can be satisfied with three or less bonding pads. Thus, the device can be driven with two or three bonding pads.

However, if the area of a chip is 4mm² or more, an area ratio at which bonding pads occupy is less than 3% even though the number of bonding pads is 10. Therefore, the effect of shielding vertically emitted light is not large. If an area ratio smaller than 3% is required, it is appropriate to adjust the number of bonding pads to be formed in accordance with FIG. 20.

As described above, in the light emitting device package according to the third embodiment not forming part of the claimed invention, a conductive pad for wire bonding is positioned outside an LED and one or both faces of the LED are electrically connected to the conductive pad, contrary to the prior art in which wire bonding is performed directly to an ohmic contact metal layer positioned on the top of an LED.

As described above, such a connection structure has been referred to as an "interconnection portion" in the third embodiment not forming part of the claimed invention and is a kind of conductive line as in the first and second embodiments.

Advantages obtained from the aforementioned structural features of the light emitting device according to the third embodiment not forming part of the claimed invention are as follows.
1) A conventional LED is finally fabricated to have a structure in which a wire bonding portion exists on the top of the LED as shown in FIGS. 3a and 3b by performing wire bonding directly on an ohmic contact metal layer existing on the top of the LED.
   Due to the wire bonding portion existing on the top of the LED in such a manner, it is difficult to perform a subsequent operation for uniformly applying a phosphor with a small thickness, and the phosphor is formed in a spherical shape due to surface tension of epoxy or silicone so that there is difference in a travel distance of light passing through the phosphor. Thus, the amount of light absorbed by the phosphor varies, resulting in ununiformity of a color and reduction of light output.
   Further, difference in the absorption by the phosphor may be reduced by applying the phosphor in the form of a thin film as shown in FIG. 3b. Since the position of the wire bonding pad is not basically changed but is on the top of the LED, however, the application of the phosphor appliance is still difficult and costs required for the application and difficulty of a process are increased.
   On the contrary, since the position of a wire bonding portion itself is basically moved outside an LED portion in the present invention, a phosphor can be applied as a thin film on the top of the LED portion, and accordingly, light loss in the phosphor can be minimized.
2) Further, since a three-dimensional obstacle due to wire bonding is removed from the surface of an LED, a phosphor can be simultaneously applied to unit chips regularly arranged on a substrate by means of a method such as screen printing. Thus, economical efficiency can be improved through reduction of manufacturing costs and mass production.
3) Furthermore, an area where vertically emitted light is absorbed can be reduced to basically improve light extraction efficiency of a light emitting diode in the third embodiment of the present invention.

In addition, the interconnection portion in the third embodiment of the present invention serves as wiring for electrical connection and preferably has the shape of a thin film deposited by means of patterning. If a material forming the interconnection portion is a conductive material, specific examples thereof include, but not limited to, Ag, Cu, Au, Al, Ti, Ni, Cr, Rh, Ir, Mo, W, Co, Zn, Cd, Ru, In, Os, Fe, Sn and a mixture (alloy) thereof.

The interconnection portion is a portion of an electrical connection line existing within an LED. One end of the interconnection portion is connected to a conductive pad positioned outside the LED and the other end thereof is connected to one or both faces of the LED, preferably the top of the LED.

In addition, the conductive pad connected to the interconnection portion in the third embodiment not forming part of the claimed invention may be connected through a wire to an external power source, e.g., a lead frame. Further, connection of the conductive pad to the external power source through a feature similar to the interconnection portion, i.e., a patterned feature of a deposited thin film, rather than a wire also falls within the scope of the present invention.

Furthermore, the conductive pad may exist outside the LED, e.g., on the same substrate on which the LED is bonded. If possible, two or more conductive pads preferably exist. A material forming the conductive pad is not limited to a specific material but may be any material so far as it has conductivity. The conductive pad is preferably made of Au, Ag, Cu, Al, Cr, Ti, Ni, In, Pt or a mixture thereof.

Moreover, the substrate on which the conductive pad is positioned may have conductivity, and the conductive pad is electrically insulated from the conductive substrate through an insulation film formed on the substrate.

One face of the LED may be electrically connected to the conductive pad through the foregoing interconnection portion and the other face of the LED bonded to the substrate may be electrically connected to the external power source. At this time, the other face of the LED may be electrically connected to a wire through another conductive pad adjacent to the bottom of the LED and subsequently to the external power source.

An insulation film should be formed on a connection path where the surface of the LED and the conductive pad are connected to each other through the interconnection portion, thereby preventing an electrical short. In forming the interconnection portion on the insulation film, it is appropriate not to form the insulation film on a contact portion of the LED connected to the interconnection portion, so that the interconnection portion can be connected to the LED.

Further, the insulation film in the third embodiment of the present invention preferably has transparency to minimize absorption of light emitted through side and top faces of the LED. As for an available component of the insulation film, there is no limitation thereon so far as the component has non-conductivity and transparency. For example, the component includes SiO₂, SiNₓ and the like.

Furthermore, although there is no specific limitation on the widths of the insulation film and the interconnection portion, it is preferred that the width of the insulation film be larger than that of the interconnection portion and the width of the interconnection portion be smaller than that of a wire.

Preferably, one or both faces of the LED, preferably a surface of the LED connected through the interconnection portion in the third embodiment not forming part of the claimed invention is a surface that is not adjacent to the substrate when the LED is mounted on the substrate.

Particularly, the surface of the LED is preferably connected to an ohmic contact metal layer to improve light emitting efficiency through resistance reduction.

At this time, the ohmic contact metal layer may be an n-ohmic contact metal layer or p-ohmic contact metal layer in accordance with methods for manufacturing LEDs, e.g., a method for manufacturing a low/medium output type LED, a method for manufacturing a high output type LED, a laser lift-off method, and the like. Further, the ohmic contact metal layer may be formed of one, or two or more discrete patterns, and each of the patterns may be connected to at least one interconnection portion.

A typical metal known in the art, e.g., Ni, Au, Pt or the like, can be used for the ohmic contact metal layer, and a metal layer of Ag, Al, Cr or the like may be additionally used to reflect light. If necessary, a metal layer may be further added to improve bonding.

Moreover, in the LED having at least one conductive interconnection portion according to the third embodiment not forming part of the claimed invention, a layer made of solely a phosphor or a mixture a molding material and a phosphor may be formed on a portion or entire of the surfaces of the LED and interconnection portion.

Further, a phosphor layer may also be formed on a portion or entire of the surface of the conductive pad, and is preferably formed on a portion of the surface of the conductive pad to facilitate wire bonding to an external power source. If the phosphor layer is formed on the entire of the surface of the conductive pad, wire bonding may be performed by forming a hole.

As described above, the present invention has advantages in that a light emitting device is electrically connected to other devices without use of wire bonding, thereby saving a space for wire bonding and reducing the size of a package.

Further, the present invention has an advantage in that a short or disconnection caused by wire bonding is reduced, resulting in improved reliability of a package.

Furthermore, there are advantages in that a light transmitting material film is coated on a substrate with a light emitting device mounted thereon so that an additional passivation film capable of protecting the light emitting device cannot be required, and wire bonding is not required so that manufacturing costs can be reduced and mass production can be made.

Moreover, the present invention has advantages in that there is no wire in a light emitting device by using a conductive interconnection portion so that a phosphor can be easily and uniformly applied, and an area where vertically emitted light is absorbed can be reduced so that light extraction of a device can be enhanced.

Although the present invention has been described in detail in connection with the specific embodiments, it will be readily apparent to those skilled in the art that various modifications and changes can be made thereto within the scope of the present invention defined by the appended claims.

## Claims

1. A method for manufacturing a light emitting device package, comprising the steps of:
mounting a light emitting device (300) having an electrode pad (301, 302) formed on at least one of the top and bottom of the light emitting device on a substrate (202) with a conductive pad (210) formed thereon;
forming a light transmitting material film (400) for surrounding the conductive pad and the light emitting device while exposing a portion of each of the conductive pad and the electrode pad formed on the at least one of the top and bottom of the light emitting device by etching; and
forming a conductive line (500) formed along a surface of the light transmitting material film from the exposed portion of the conductive pad to the exposed portion of the electrode pad of the light emitting device,
wherein the light transmitting material film is formed by coating a light transmitting material on the conductive pad and the light emitting device to form a film and selectively removing the film to expose a portion of each of the conductive pad and the electrode pad formed on the top of the light emitting device,
**characterized in that**:
the light transmitting material film is made of a photosensitive substance through which light can be transmitted,
the substrate is a conductive substrate, and
an insulation film (250) is further interposed between the conductive pad and the conductive substrate, wherein the film is formed by means of a spray coating method. wherein the film is formed by means of a spray coating method.

2. The method as claimed in claim 1, wherein the step of forming the light transmitting material film comprises the steps of:
forming a flat film having a flat upper portion and surrounding the conductive pad and the light emitting device;
forming a pair of trenches by removing portions of the flat film from the top of the flat film respectively to the conductive pad and the electrode pad of the light emitting device; and
filling the pair of trenches with a conductive material and forming a conductive layer for connecting the conductive material filled in the trenches to each other.

3. The method as claimed in claim 1, wherein a phosphor for converting the wavelength of light emitted from the light emitting device is dispersed in the light transmitting material film.

4. The method as claimed in claim 1, wherein the conductive line is formed by performing a lift-off process.

## Patentansprüche

1. Verfahren zur Herstellung eines Gehäuses einer lichtemittierenden Vorrichtung, das die folgenden Schritte umfasst:
Montieren einer lichtemittierenden Vorrichtung (300), die eine Elektrodenanschlussfläche (301, 302) aufweist, die auf zumindest einer der Oberseite und der Unterseite der lichtemittierenden Vorrichtung ausgebildet ist, auf einem Substrat (202), auf dem eine leitfähige Anschlussfläche (210) ausgebildet ist;
Ausbilden eines lichtübertragenden Materialfilms (400) zum Umgeben der leitfähigen
Anschlussfläche und
der lichtemittierenden Vorrichtung, während ein Abschnitt jeder der leitfähigen Anschlussfläche und der Elektrodenanschlussfläche, die auf der zumindest einen der Oberseite und der Unterseite der lichtemittierenden Vorrichtung ausgebildet ist, durch Ätzen freigelegt wird; und
Ausbilden einer Leiterbahn (500), die entlang einer Oberfläche des lichtübertragenden Materialfilms ausgebildet ist, von dem freigelegten Abschnitt der leitfähigen Anschlussfläche zu dem freigelegten Abschnitt der Elektrodenanschlussfläche der lichtemittierenden Vorrichtung,
wobei der lichtübertragende Materialfilm ausgebildet wird, indem ein lichtübertragendes Material auf der leitfähigen Anschlussfläche und der lichtemittierenden Vorrichtung aufgetragen wird, um einen Film auszubilden, und der Film selektiv entfernt wird, um einen Abschnitt jeder der leitfähigen Anschlussfläche und der Elektrodenanschlussfläche, die auf der Oberseite der lichtemittierenden Vorrichtung ausgebildet ist, freizulegen,
**dadurch gekennzeichnet, dass**:
der lichtübertragende Materialfilm aus einer lichtempfindlichen Substanz, durch die Licht übertragen werden kann, hergestellt ist,
das Substrat ein leitfähiges Substrat ist und
ein Isolierfilm (250) ferner zwischen der leitfähigen Anschlussfläche und dem leitfähigen Substrat angeordnet ist, wobei der Film mittels eines Sprühbeschichtungsverfahrens ausgebildet wird.

2. Verfahren nach Anspruch 1, wobei der Schritt des Ausbildens des lichtübertragenden Materialfilms die folgenden Schritte umfasst:
Ausbilden eines flachen Films, der einen flachen oberen Abschnitt aufweist und die leitfähige Anschlussfläche und die lichtemittierende Vorrichtung umgibt;
Ausbilden eines Paars von Trenches durch Entfernen von Abschnitten des flachen Films von der Oberseite des flachen Films zu der leitfähigen Anschlussfläche bzw. der Elektrodenanschlussfläche der lichtemittierenden Vorrichtung; und
Befüllen des Paars von Trenches mit einem leitfähigen Material und Ausbilden einer leitfähigen Schicht zum Verbinden des leitfähigen Materials, das in die Trenches gefüllt wurde, miteinander.

3. Verfahren nach Anspruch 1, wobei ein Leuchtstoff zum Umwandeln der Wellenlänge von Licht, das von der lichtemittierenden Vorrichtung emittiert wurde, in dem lichtübertragenden Materialfilm dispergiert wird.

4. Verfahren nach Anspruch 1, wobei die Leiterbahn durch Ausführen eines Abhebeverfahrens ausgebildet wird.

## Revendications

1. Procédé de fabrication d'un boîtier de dispositif émetteur de lumière, comprenant les étapes suivantes :
le montage d'un dispositif émetteur de lumière (300) ayant une pastille d'électrode (301, 302) formée sur au moins l'un parmi le haut et le bas du dispositif émetteur de lumière sur un substrat (202) ayant une pastille conductrice (210) formée dessus ;
la formation d'un film de matériau transmettant la lumière (400) pour entourer la pastille conductrice et le dispositif émetteur de lumière tout en exposant une partie de chacun parmi la pastille conductrice et la pastille d'électrode formée sur l'au moins un parmi le haut et le bas du dispositif émetteur de lumière par gravure ; et
la formation d'une ligne conductrice (500) formée le long d'une surface du film de matériau transmettant la lumière à partir de la partie exposée de la pastille conductrice vers la partie exposée de la pastille d'électrode du dispositif émetteur de lumière,
dans lequel le film de matériau transmettant la lumière est formé par le revêtement d'un matériau transmettant la lumière sur la pastille conductrice et le dispositif émetteur de lumière pour former un film et l'élimination sélective du film pour exposer une partie de chacun parmi la pastille conductrice et la pastille d'électrode formée sur le haut du dispositif émetteur de lumière,
**caractérisé en ce que** :
le film de matériau transmettant la lumière est fait d'une substance photosensible à travers laquelle une lumière peut être transmise,
le substrat est un substrat conducteur, et
un film isolant (250) est en outre intercalé entre la pastille conductrice et le substrat conducteur, dans lequel le film est formé au moyen d'un procédé de revêtement par pulvérisation.
dans lequel le film est formé au moyen d'un procédé de revêtement par pulvérisation.

2. Procédé selon la revendication 1, dans lequel l'étape de formation du film de matériau transmettant la lumière comprend les étapes suivantes :
la formation d'un film plat ayant une partie supérieure plate et entourant la pastille conductrice et le dispositif émetteur de lumière ;
la formation d'une paire de tranchées par l'élimination de parties du film plat à partir du haut du film plat respectivement vers la pastille conductrice et la pastille d'électrode du dispositif émetteur de lumière ; et
le remplissage de la paire de tranchées avec un matériau conducteur et la formation d'une couche conductrice pour connecter le matériau conducteur introduit dans les tranchées l'un à l'autre.

3. Procédé selon la revendication 1, dans lequel une substance luminescente pour convertir la longueur d'onde de la lumière émise à partir du dispositif émetteur de lumière est dispersée dans le film de matériau transmettant la lumière.

4. Procédé selon la revendication 1, dans lequel la ligne conductrice est formée par la mise en oeuvre d'un procédé de décollage.
